# EUROPEAN PATENT SPECIFICATION

(11) **EP 2 067 075 B1**
(45) Date of publication and mention of the grant of the patent: **01.05.2013**
(21) Application number: 07837969.0
(22) Date of filing: 07.09.2007
(51) Int. Cl.: G03F 7/00

(54) **METHOD TO FORM A PATTERN OF FUNCTIONAL MATERIAL ON A SUBSTRATE**
VERFAHREN ZUR STRUKTURFORMUNG EINES FUNKTIONSMATERIALS AUF EINEM SUBSTRAT
PROCÉDÉ DE FORMATION D'UN MOTIF DE MATÉRIAU FONCTIONNEL SUR UN SUBSTRAT

(30) Priority: 28.09.2006 US 529086
(43) Date of publication of application: 10.06.2009
(73) Proprietor: E.I. DU PONT DE NEMOURS AND COMPANY, Wilmington, DE 19898 (US)
(72) Inventor: BLANCHET, Graciela, Beatriz, Wilmington, Delaware 19806 (US); LEE, Hee Hyun, Greenville, Delaware 19807 (US); JAYCOX, Gary, Delmar, West Chester, Pennsylvania 19382 (US)
(74) Representative: Towler, Philip Dean
(86) International application number: PCT/US2007/019653
(87) International publication number: WO 2008/042079

(56) References cited:
- EP-A- 1 538 481
- WO-A-02/085639
- WO-A-03/023082
- WO-A-2004/092836
- WO-A2-2008/005208
- CA-A1- 2 523 896
- GB-A- 2 368 190
- US-A1- 2002 130 444
- US-A1- 2005 118 338
- US-A1- 2005 139 103
- US-A1- 2006 021 533
- SCHMID H ET AL: "Siloxane polymers for high-resolution, high-accuracy soft lithography" MACROMOLECULES, ACS, WASHINGTON, DC, US, vol. 33, no. 8, 25 March 2000 (2000-03-25), pages 3042-3049, XP002385970 ISSN: 0024-9297

## Description

### BACKGROUND OF THE INVENTION

### 1. Field of the Invention

This invention pertains to a method for forming a pattern of functional material on a substrate, and in particular, the method uses an elastomeric stamp having a raised surface to form the pattern on the substrate for use in microfabrication of components and devices.

### 2. Description of Related Art

Nearly all electronic and optical devices require patterning. Microelectronic devices have been prepared by photolithographic processes to form the necessary patterns. According to this technique a thin film of conducting, insulating or semiconducting material is deposited on a substrate and a negative or positive photoresist is coated onto the exposed surface of the material. The resist is then irradiated in a predetermined pattern, and irradiated or non-irradiated portions of the resist are washed from the surface to produce a predetermined pattern of resist on the surface. To form a pattern of a conducting metal material, the metal material that is not covered by the predetermined resist pattern is then etched or removed. The resist pattern is then removed to obtain the pattern of metal material. Photolithography, however, is a complex, multi-step process that is too costly for the printing of plastic electronics.

Contact printing is a-flexible, non-lithographic method for forming patterned materials. Contact printing potentially provides a significant advance over conventional photolithographic techniques since the contact printing can form relatively high resolution patterns on plastic electronics for electronic parts assembly. Microcontact printing can be characterized as a high-resolution technique that enables patterns of micron dimensions to be imparted onto a substrate surface. Microcontact printing is also more economical than photolithography systems since it is procedurally less complex, ultimately not requiring spin coating equipment or a sequential development step. In addition, microcontact printing potentially lends itself to reel-to-reel electronic parts assembly operations that allows for high throughput production than other techniques, such as photolithography and e-beam lithography (which is a conventional technique employed where resolution on the order of 10s of nanometer is desired). Multiple images can be printed from a single stamp in reel-to-reel assembly operations using microcontact printing.

Contact printing is a possible replacement to photolithography in the fabrication of microelectronic devices, such as radio frequency tags (RFID), sensors, and memory and backpanel displays. The capability of microcontact printing to transfer a self-assembled monolayer (SAM) forming molecular species to a substrate has also found application in patterned electroless deposition of metals. SAM printing is capable of creating high resolution patterns, but is generally limited to forming metal patterns of gold or silver with thiol chemistry. Although there are variations, in SAM printing a positive relief pattern provided on an elastomeric stamp is inked onto a substrate. The relief pattern of the elastomeric stamp, which is typically made of polydimethylsiloxane (PDMS), is inked with a thiol material. Typically the thiol material is an alkane thiol material. The substrate is blanket-coated with a thin metal film of gold or silver, and then the gold-coated substrate is contacted with the stamp. Upon contact of the relief pattern of the stamp with the metal film, a monolayer of the thiol material having the desired microcircuit pattern is transferred to the metal film. Alkane thiols form an ordered monolayer on metal by a self-assembly process, which results in the SAM being tightly packed and well adhered to the metal. As such, the SAM acts as an etch resist when the inked substrate is then immersed in a metal etching solution and all but the SAM-protected metal areas are etched away to the underlying substrate. The SAM is then stripped away leaving the metal in the desired pattern.

A method of transferring a material to a substrate, particularly for light emitting devices, is disclosed by Coe-Sullivan et al. in WO 2006/047215. The method includes selectively depositing the material on a surface of a stamp applicator and contacting the surface of the stamp applicator to the substrate. The stamp applicator may be textured, that is have a surface with a pattern of elevations and depressions, or may be featureless, that is, having no elevations or depressions. The material is a nanomaterial ink that includes semiconductor nanocrystals. Direct contact printing of the material on the substrate eliminates the steps associated with SAM printing in which excess material that does not form the desired microcircuitry pattern from the substrate is etched away or removed. The stamp applicator can be made of an elastomeric material such as polydimethylsiloxane (PDMS).

Although it has been shown that 20 nm features can be achieved when printing via thiol chemistry, it is limited to a few metals and is not compatible with reel-to-reel processes. In contrast, it is difficult to form patterns of functional material with resolution on the order of 50 micron or less, and particularly 1 to 5 micron, by direct relief printing of the functional material. WO-A-03023082 discloses epoxy and acrylic polymers as well as alloxanes as stamp materials for microcontact printing; EP-A-1538481 and US-A-2005118338 disclose PDMS stamps for microcontact printing, US-A-2006021533 and WO-A-2008005208 stamps on the basis of Fluoropolymers for printing reliefs into deformable substrates.

So it is desirable to provide a method for forming a pattern of a functional material onto a substrate. It is desirable for the method to directly form the pattern of the functional material on the substrate. It is particularly desirable to directly form the pattern of a conductive material on the substrate and thereby eliminate the intermediate etching steps for removing the conductive material not forming the pattern. It is also desirable for such method to have the ease of microcontact printing with an elastomeric stamp and capable of reproducing resolution of 50 micron or less, and particularly on the order of 1 to 5 micron, but not be limited to printing onto metals. It is also desirable for such a method to avoid the problem of transfer of the functional material in featureless areas of the pattern.

### SUMMARY

The present invention provides a method to form a pattern of functional material on a substrate. The method includes providing an elastomeric stamp having a relief structure with a raised surface, the stamp having a modulus of elasticity of at least 10 MegaPascal, wherein the elastomeric stamp is formed from a layer of a composition comprising a fluorinated compound capable of polymerization by exposure to actinic radiation. A liquid composition comprising the functional material and a liquid is applied to the relief structure of the stamp, and the liquid is removed from the composition on the relief structure sufficiently to form a film of the functional material on at least the raised surface. The functional material transfers from the raised surface to form the pattern on the substrate. The invention is defined in the claims.

### BRIEF DESCRIPTION OF THE DRAWINGS

Figure 1 is a sectional elevation view of a master having a relief structure that forms a pattern of a microcircuit or other functional electronic pathway.
Figure 2 is a sectional elevation view of one embodiment of a printing form precursor having a layer of an elastomeric material between a support and the master, the elastomeric layer being exposed to actinic radiation.
Figure 3 is a sectional elevation view of a stamp formed from the printing form precursor separating from the master. The stamp has a relief structure corresponding to the relief pattern of the master, and in particular, the relief structure of the stamp includes a pattern of at least a raised surface and a recessed surface that is the opposite of the relief of the master.
Figure 4 is a sectional elevation view of the elastomeric stamp residing on a platform of a spin coater as one embodiment of applying a functional material to the relief structure of the stamp.
Figure 5 is a sectional elevation view of the elastomeric stamp having the layer of functional material on the raised surface of the relief structure contacting a substrate.
Figure 6 is a sectional elevation view of the elastomeric stamp separating from the substrate, and transferring the functional material on the raised surface to the substrate to form a pattern of the functional material.

### DESCRIPTION OF THE PREFERRED EMBODIMENT(S)

Throughout the following detailed description, similar reference characters refer to similar elements in all figures of the drawings.

The present invention provides a method to form a pattern of a functional material on a substrate for use in devices and components in a variety of applications, including but not limited to, electronic, optical, sensory, and diagnostic applications. The method is applicable to the pattern formation of a variety of active materials and inactive materials as the functional material. The method is not limited to the application by elastomeric stamps of thiol materials as a masking material. The method is capable of directly forming the pattern of the functional material onto a variety of substrates over large areas with line resolution of less than 50 micron, and thus is particularly capable of forming microcircuitry. Fine line resolution of 1 to 5 micron can even be attained by the present method. The method employs the ease of printing with an elastomeric stamp having a relief structure to transfer the functional material, without sagging or substantial sagging of the stamp and undesired transfer of material to the substrate. The method provides clean, featureless (open) background area between the lines of functional material, while retaining image fidelity and resolution associated with conventional microcontact printing. The present method enables printing of a variety of functional materials over relatively large areas with micron resolution. The method also enables printing of sequential overlays without hampering the functionality of one or more underlying layers. The method can be adapted to high-speed production processes particularly for the fabrication of electronic devices and components, such as reel-to-reel processes.

A stamp is provided for patterning a substrate. The stamp includes a relief structure with a raised surface. Typically the relief structure will include a plurality of raised surfaces and a plurality of recessed surfaces. The relief structure of the stamp forms a pattern of raised surfaces for printing a functional material on a substrate. The pattern of the functional material on the substrate provides an operative function to a component or device. The raised surfaces of the relief structure of the elastomeric stamp represent the pattern of the function material that will ultimately be formed on the substrate by the present method, and the recessed surfaces represent the background or featureless areas on the substrate. The present method uses an elastomeric stamp having a modulus of elasticity of at least 10 MegaPascal (Mpa), which provides the capability to form features of various functional materials on the substrate of less than 50 micron resolution. The method is capable of forming line resolution less than 30 micron, to as fine as 1 to 5 micron. In some embodiments where the functional material is, for example, a semiconductor or a dielectric material, resolution of less than 50 micron is acceptable since this resolution meets the requirements in electronic devices and components. In some embodiments where the functional material is, for example, a conductive material, the method is capable of forming features of 1 to 5 micron. The present method directly prints a pattern of the functional material on the substrate, and thus eliminates the intermediate etching steps associated with standard microcontact printing for forming conductive patterns. In some embodiments, the present method may also minimize transfer of the functional material to non-pattern areas on the substrate that typically occurs from stamp sagging (i.e., roof collapse in the recessed portions). The present method is applicable to forming patterns of functional material regardless of the relative dimensions of the raised surfaces and the recessed surfaces of the stamp.

The stamp may be formed in conventional fashion as understood by those skilled in the art of microcontact printing. For example, a stamp may be fabricated by molding and curing a layer of a material on a master having a surface presenting a relief form (that is in opposite of the stamp relief structure). The stamp is cured by exposure to actinic radiation. The stamp thus includes a layer of the elastomeric material, which may be referred to as an elastomeric layer, cured layer, or cured elastomeric layer as defined in claim 1. The relief structure of the stamp is such that the raised surface has a height from the recessed surface sufficient for selective contact of the raised surface with a substrate. The height from the recessed surface to the raised surface may also be called a relief depth. In one embodiment, the raised surface has a height from the recessed surface of about 0.2 to 20 micron. In another embodiment, the raised surface has a height from the recessed surface of about 0.2 to 2 micron. The elastomeric layer forming the stamp has a thickness that is not particularly limited provided that the relief structure can be formed in the layer for printing. In one embodiment, the thickness of the elastomeric layer is between 1 to 51 micron. In another embodiment, the thickness of the elastomeric layer is between 5 to 25 micron.

The elastomeric layer provides the resulting stamp with a modulus of elasticity of at least 10 MegaPascal, and preferably greater than 10 MegaPascal. The modulus of elasticity is a ratio of an increment of stress to an increment of strain. For the present method the modulus of elasticity is the Young's modulus where at low strains the relationship between stress and strain is linear, such that a material can recover from stress and strain. The modulus of elasticity may also be referred to as coefficient of elasticity, elasticity modulus, or elastic modulus. The modulus of elasticity is a mechanical property well known to those of ordinary skill. A description of the modulus of elasticity and other mechanical properties of materials, and analysis thereof, can be found in Marks' Standard Handbook for Mechanical Engineers, eds. Avalone, E. and Baumeister III, T., 9th edition, Chapter 5, McGraw Hill, 1987. A suitable method for determining the modulus of elasticity of the elastomeric stamp is described by Oliver and Pharr in J. Mater. Res. 7, 1564 (1992). This method is particularly suited for determining the modulus of elasticity for a thin elastomeric layer, such as the elastomeric layer forming the stamp that is less than 51 micron thick. The modulus of elasticity for the printing stamp can be measured on an indentation tester (Indenter) equipped with an indenter tip that is normal to a sample surface and having a known geometry. The indenter tip is driven into the sample by applying an increasing load up to some preset value. The load is then gradually decreased until partial or complete relaxation of the sample has occurred. Multiple sets of indentations in the sample can be done. The load/unload and displacement are recorded continuously throughout the test process to produce a load displacement curve from which mechanical properties, such as the modulus of elasticity and others, can be determined. The analysis of the load/unload curves for each indentation is conducted according to the method described by Oliver and Pharr originally introduced in the J. Mater. Res.

The material forming the stamp is elastomeric in order for at least a raised portion of the stamp to conform to a surface of the substrate so as to promote the complete transfer of the functional material thereto. The modulus of elasticity of at least 10 MegaPascal assures that the stamp can reproduce a fine resolution pattern of the functional material on the substrate by direct relief printing. Stamps with a modulus of elasticity of at least 10 MegaPascal, are capable of improved resolution by contact printing of the functional material to the substrate. In some embodiments of the stamp having a modulus of elasticity of at least 10 MegaPascal, the stamp exhibits less sagging in recessed areas. In one embodiment, the elastomeric stamp has a modulus of elasticity of at least 11 MegaPascal. In one embodiment, the elastomeric stamp has a modulus of elasticity of at least 15 MegaPascal. In another embodiment, the elastomeric stamp has a modulus of elasticity of at least 20 MegaPascal. In another embodiment, the elastomeric stamp has a modulus of elasticity of at least 40 MegaPascal.

The stamp can be fabricated from any material or combination of materials that is capable of reproducing by relief printing a pattern of functional material on the substrate. Polymeric materials suitable for forming the elastomeric stamp are fluorinated compounds capable of polymerization which can provide the stamp with the modulus of elasticity of at least 10 MegaPascal. Selection of the material used for the elastomeric stamp may in part be dependent upon the composition of the functional material and the liquid being applied to/by the stamp. For example, the material selected for the elastomeric stamp should be resistant to swelling while in contact with the composition, and in particular, the liquid. Fluoropolymers are typically resistant to organic solvents (for the functional material). Certain solvents, such as chloroform, used with the functional material tend to swell silicone based stamps, such as PDMS not covered by the invention. Swelling of the stamp will alter the capability to produce fine resolution patterns on the substrate. The polymeric material may be elastomeric or may become elastomeric upon curing. The polymeric material may itself be photosensitive and/or the polymeric material may be included with one or more additives in a composition to render the composition photosensitive.

The material forming the elastomeric stamp is photosensitive such that the relief structure can be formed upon exposure to actinic radiation. The term "photosensitive" encompasses any system comprising fluorinated compounds in which the photosensitive composition is capable of initiating a reaction or reactions, particularly photochemical reactions, upon response to actinic radiation. Upon exposure to actinic radiation, chain propagated polymerization of a monomer and/or oligomer is induced by either a condensation mechanism or by free radical addition polymerization. While all photopolymerizable mechanisms are contemplated, photosensitive compositions useful as elastomeric stamp material will be described in the context of free-radical initiated addition polymerization of monomers and/or oligomers having one or more terminal ethylenically unsaturated groups. In this context, the photoinitiator system when exposed to actinic radiation can act as a source of free radicals needed to initiate polymerization of the monomer and/or oligomer.

The composition is photosensitive since the composition contains a compound having at least one ethylenically unsaturated group capable of forming a polymer by photoinitiated addition polymerization. The photosensitive composition may also contain an initiating system activated by actinic radiation to induce photopolymerization. The polymerizable compound may have non-terminal ethylenically unsaturated groups, and/or the composition may contain one or more other components, such as a monomer, that promote crosslinking. As such, the term "photopolymerizable" is intended to encompass systems that are photopolymerizable, photocrosslinkable, or both. As used herein, photopolymerization may also be referred to as curing. The photosensitive composition forming the elastomeric stamp may include one or more constituents and/or additives, and can include, but is not limited to photoinitiators, one or more ethylenically unsaturated compounds (which may be referred to as monomers), fillers, surfactants, thermal polymerization inhibitors, processing aids, antioxidants, photosensitizers, and the like to stabilize or otherwise enhance the composition.

The photoinitiator can be any single compound or combination of compounds, which is sensitive to actinic radiation, generating free radicals which initiate the polymerization without excessive termination. Any of the known classes of photoinitiators, particularly free radical photoinitiators such as aromatic ketones, quinones, benzophenones, benzoin ethers, aryl ketones, peroxides, biimidazoles, benzyl dimethyl ketal, hydroxyl alkyl phenyl acetophone, dialkoxy actophenone, trimethylbenzoyl phosphine oxide derivatives, aminoketones, benzoyl cyclohexanol, methyl thio phenyl morpholino ketones, morpholino phenyl amino ketones, alpha halogennoacetophenones, oxysulfonyl ketones, sulfonyl ketones, oxysulfonyl ketones, sulfonyl ketones, benzoyl oxime esters, thioxanthrones, camphorquinones, ketocouumarins, and Michler's ketone may be used. In one embodiment, the photoinitiator can include a fluorinated photoinitiator that is based on known fluorine-free photoinitiators of the aromatic ketone type. Alternatively, the photoinitiator may be a mixture of compounds, one of which provides the free radicals when caused to do so by a sensitizer activated by radiation. Liquid photoinitiators are particularly suitable since they disperse well in the composition. Preferably, the initiator is sensitive to ultraviolet radiation. Photoinitiators are generally present in amounts from 0.001% to 10.0% based on the weight of the photosensitive composition.

Monomers that can be used in the composition activated by actinic radiation are well known in the art, and include, but are not limited to, addition-polymerization ethylenically unsaturated compounds. The addition polymerization compound may also be an oligomer, and can be a single or a mixture of oligomers. The composition can contain a single monomer or a combination of monomers. The monomer compound capable of addition polymerization can be present in an amount less than 5%, preferably less than 3%, by weight of the composition.

The elastomeric stamp is composed of a photosensitive composition that includes a fluorinated compound that polymerizes upon exposure to actinic radiation to form a fluorinated elastomeric-based material. Suitable elastomeric-based fluorinated compounds include, but are not limited to, perfluoropolyethers, fluoroolefins, fluorinated thermoplastic elastomers, fluorinated epoxy resins, fluorinated monomers and fluorinated oligomers that can be polymerized or crosslinked by a polymerization reaction. In one embodiment, the fluorinated compound has one or more terminal ethylenically unsaturated groups that react to polymerize and form the fluorinated elastomeric material. The elastomeric-based fluorinated compounds can be homopolymerized or copolymerized with polymers such as polyurethanes, polyacrylates, polyesters, polysiloxanes, polyamides, and others, to attain desired characteristics of the printing form precursor and/or the stamp suitable for its use. Exposure to the actinic radiation is sufficient to polymerize the fluorinated compound and render its use as a printing stamp, such that application of high pressure and/or elevated temperatures above room temperature is not necessary. An advantage of compositions containing fluorinated compounds that cure by exposure to actinic radiation is that the composition cures relatively quickly (e.g., in a minutes or less) and has a simple process development, particularly when compared to compositions that thermally cure such as PDMS based systems.

In one embodiment, the elastomeric stamp includes a layer of the photosensitive composition wherein the fluorinated compound is a perfluoropolyether (PFPE) compound. A perfluoropolyether compound is a compound that includes at least a primary proportion of perfluoroether segments, i.e., perfluoropolyether. The primary proportion of perfluoroether segments present in the PFPE compound is equal to or greater than 80 weight percent, based on the total weight of the PFPE compound. The perfluoropolyether compound may also include one or more extending segments that are hydrocarbons or hydrocarbon ethers that are not fluorinated; and/or, are hydrocarbons or hydrocarbon ethers that may be fluorinated but are not perfluorinated. In one embodiment, the perfluoropolyether compound includes at least the primary proportion of perfluoropolyether segments and terminal photoreactive segments, and optionally extending segments of hydrocarbon that are not fluorinated. The perfluoropolyether compound is functionalized with one or more terminal ethylenically unsaturated groups that render the compound reactive to the actinic radiation (i.e., photoreactive segments). The photoreactive segments may also be referred to as photopolymerizable segments.

The perfluoropolyether compound is not limited, and includes linear and branched structures, with linear backbone structures of the perfluoropolyether compound being preferred. The PFPE compound may be monomeric, but typically is oligomeric and a liquid at room temperature. The perfluoropolyether compound may be considered an oligomeric difunctional monomer having oligomeric perfluoroether segments. Perfluoropolyether compounds photochemically polymerize to yield the elastomeric layer of the stamp. An advantage of the PFPE based materials is that PFPEs are highly fluorinated and resist swelling by organic solvents, such as methylene chloride, chloroform, tetrahydrofuran, toluene, hexanes, and acetonitrile among others, which are desirable for use in microcontact printing techniques.

Optionally, the elastomeric stamp may include a support of a flexible film, and preferably a flexible polymeric film. The flexible support is capable of conforming or substantially conforming the elastomeric relief surface of the stamp to a printable electronic substrate, without warping or distortion. The support is also sufficiently flexible to be able to bend with the elastomeric layer of the stamp while peeling the stamp from the master. The support can be any polymeric material that forms a film that is non-reactive and remains stable throughout conditions for making and using the stamp. Examples of suitable film supports include cellulosic films such as triacetyl cellulose; and thermoplastic materials such as polyolefins, polycarbonates, polyimides, and polyester. Preferred are films of polyethylene, such as polyethylene terephthalate and polyethylene napthalate. Also encompassed within a support is a flexible glass. Typically the support has a thickness between 2 to 50 mils (0.0051 to 0.13 cm). Typically the support is in the form of a sheet film, but is not limited to this form. In one embodiment, the support is transparent or substantially transparent to the actinic radiation at which the photosensitive composition polymerizes.

Optionally, the elastomeric stamp may include one or more layers on the relief surface prior to the application of the functional material. The one or more layers may, for example, assist in the transfer of the functional material from the stamp to the substrate. An example of a material suitable for use as the additional layer includes fluorinated compounds. In one embodiment, the additional layer remains with the elastomeric stamp after transfer of the functional material to the substrate.

The functional material is a material that is patterned by microfabrication to facilitate an operation in a variety of components and devices. The functional material can be an active material or an inactive material. Active materials include, but are not limited to, electrically active materials, photoactive materials, and biologically active materials. As used herein, the terms "electrically active", "photoactive" and "biologically active" refer to a material which exhibits a predetermined activity in response to a stimulus, such as an electromagnetic field, an electrical potential, solar or other energy radiation, a biostimulation field, or any combination thereof. Inactive materials include, but are not limited to, insulating materials, such as dielectric materials; planarization materials; barrier materials; and confinement materials. In one embodiment, the planarization material is printed on top of a pattern of pixels in color filters to render all pixels the same height. In one embodiment, the barrier material is printed pattern to form a barrier so that charges in the cathode facilitate charge injection into a light emitting polymer layer in an organic light emitting diode (OLED). In one embodiment, the confinement material is printed as a pattern that restricts the expansion of a subsequently applied liquid to a particular area defined by the pattern of confinement material. The functional materials for the inactive materials are not limited to only those used in the embodiments described above. The active materials and inactive materials can be organic or inorganic. Organic materials can be polymeric materials, or small molecule materials.

The functional material is not limited, and includes, for example, conductive materials, semi-conductive materials, and dielectric materials. Examples of conductive materials for use as a functional material include, but are not limited to, indium-tin oxide; metals, such as silver, gold, copper, and palladium; metal complexes; metal alloys; etc. Examples of semiconductive materials include, but are not limited to, silicon, germanium, gallium arsenide, zinc oxide, and zinc selenide.

The functional material can be of any form including particulate, polymeric, molecular, etc. Typically, semiconducting materials and dielectric materials are polymeric, but are not limited to this form, and functional materials can include soluble semiconducting molecules.

Functional materials for use in the present method also include nanoparticles of conductive, semi-conductive, and dielectric materials. Nanoparticles are microscopic particles whose size is measured in nanometers (nm). Nanoparticles include particles having at least one dimension less than 200 nm. In one embodiment, the nanoparticles have a diameter of about 3 to 100 nm. At the small end of the size range, the nanoparticles may be referred to as clusters. The shape of the nanoparticles is not limited and includes nanospheres, nanorods, and nanocups. Nanoparticles made of semiconducting material may also be called quantum dots, if the particles are small enough (typically less than 10 nm) that quantization of electronic energy levels occurs. Semiconducting materials include light-emitting quantum dots. A bulk material generally has constant physical properties regardless of its size, but for nanoparticles this is often not the case. Size dependent properties are observed such, as quantum confinement in semiconductor particles, surface plasmon resonance in some metal particles and superparamagnetism in magnetic materials. The functional material includes but is not limited to semi-solid nanoparticles, such as liposome; soft nanoparticles; nanocrystals; hybrid structures, such as core-shell nanoparticles. The functional material includes nanoparticles of carbon, such as carbon nanotubes, conducting carbon nanotubes, and semiconducting carbon nanotubes. Metal nanoparticles and dispersions of gold, silver and copper are commercially available from Nanotechnologies, and ANP.

The term "photoactive" is intended to mean any material that exhibits photoluminescence, electroluminescence, coloration, or photosensitivity: The term is intended to include, among others, dyes, optical whiteners, photoluminescent materials, compounds reactive to actinic radiation, and photoinitiators. In one embodiment, photoactive materials encompasses any material or combination of materials which is capable of initiating a reaction or reactions, particularly photochemical reactions, upon response to actinic radiation. Photoactive materials can include a compound which itself may be reactive to actinic radiation, and/or may include a composition of one or more compounds, such as monomers and photoinitiators, that render the composition reactive to actinic radiation. Suitable photoactive materials for the functional material include those described above as photosensitive compositions and materials suitable for the elastomeric stamp. In one embodiment the photoactive materials can be one or more fluorinated compounds, such as fluoropolymers, fluorinated monomers, and fluorinated oligomers, as described above for the elastomeric stamp. In another embodiment the functional material is an organic light emitting polymer

Further examples of functional materials that may be referred to as small molecule materials, can include, but are not restricted to, organic dyes, semi-conducting molecules, fluorescent chromophores, phosphorescent chromophores, pharmacologically active compounds, biologically active compounds and compounds having catalytic activites, that alone or in various combinations with other materials, are suitable for the fabrication of patterned devices useful for electronic, sensory or diagnostic applications.

Biologically active materials, which may also be called bio-based materials, for use in the present invention can include, but are not limited to, deoxyribonucleic acids (DNAs) of various molecular weights that can be employed as templates or scaffolds to position other materials that bind to DNA into well-defined geometries, and proteins, poly(oligo)peptides, and poly(oligo)saccharides, that alone or in various combinations with other materials, are suitable for the fabrication of patterned devices for electronic, sensory or diagnostic applications.

The functional material is typically dispersed or dissolved or suspended in a liquid, forming a composition for application to the stamp. The liquid used for the functional material is not limited and can include organic compounds and aqueous compounds. In one embodiment, the liquid is an organic compound that is an alcohol-based compound. The liquid may be a solvent, that is a substance which is capable of dissolving another substance (i.e., functional material) to form a uniform mixture, or may be a carrier compound capable of dispersing or suspending the material in solution sufficient to conduct the steps of the present method. The liquid, whether solvent or carrier, and the functional material should at least be capable of wetting at least the raised surface of the stamp during application. The functional material may be present in the liquid from 0.1 to 30 % by weight based on the total weight of the composition. The liquid may include one or more than one compounds as a solvent or carrier for the functional material. In one embodiment, the liquid includes one solvent for the functional material. In one other embodiment, the liquid solution includes one carrier compound for the functional material. In another embodiment, the liquid includes two solvents, that is, a co-solvent mixture, for the functional material. In the embodiment where a co-solvent mixture is used, the components in the mixture may be selected according to one or more of the following guidelines: (1) The evaporation rate (i.e., volatility) of the individual solvent components are different. (2) The solvating power of the individual solvent components for a particular functional material are different. The solvating power and the volatility of the individual solvent components are different enough such that a gradient in the composition and/or during removal of the liquid is created. (3) The individual solvent components are miscible with each other over the composition range that occurs during removal of the liquid from the relief structure of the stamp. (4) The co-solvent mixture continues to wet the raised surface of the stamp during removal of the liquid from the stamp. One example of a co-solvent mixture includes a very good solvent (of the functional material) that is highly volatile that forms a binary solvent solution with a poorer solvent that is less volatile. As the binary solvent solution evaporates from the raised surface of the stamp, the solution composition continuously changes (gradient). The solution gradient can drive changes in the characteristics of the functional material during removal of the liquid to form the film on the stamp. Characteristics that may change as a result of such a drying gradient include aggregation for small aromatic molecules, such as semiconductive materials, and conformation for (bio)polymers such as DNA or semi-conducting polymers. The film of the functional material that results from the drying gradient may have different characteristics, which may be physical, or chemical, or biological, that may possibly influence the state of the functional material pre- or post- transfer to the substrate.

The composition of the functional material and the liquid is provided on the stamp by applying the composition to at least the raised surface of the relief structure of the stamp. The composition of the functional material and the liquid can be applied to the stamp by any suitable method, including but not limited to, injection, pouring, liquid casting, jetting, immersion, spraying, vapor deposition, and coating. Examples of suitable methods of coating include spin coating, dip coating, slot coating, roller coating, and doctor blading. In one embodiment, the composition is applied to the stamp and forms a layer on the relief structure of the stamp, that is, the composition forms a layer on the raised surface/s and the recessed surface/s. The layer of composition on the stamp can be continuous or discontinuous. The thickness of the layer of the composition is not particularly limited. In one embodiment, the thickness of the composition layer is typically less than the relief height (difference between the raised surface and the recessed surface) of the stamp.

The composition should be capable of forming a layer on at least the raised surface of the relief structure of stamp. Beyond the requirement for the elastomeric modulus of the stamp, certain other properties of the elastomeric stamp, such as, the solvent resistance of the stamp material, as well as certain properties of the composition of the functional material, such as, the boiling point of a solvent and solubility of the functional material in the solvent, may influence the capability of a particular functional material to form a layer and transfer as a pattern to the substrate, but it is well within the skill of those in the art of microcontact printing to determine an appropriate combination of functional material and elastomeric stamp.

In one embodiment, the functional material is in a liquid solution of a solvent for application to the substrate. In another embodiment, the functional material is in a co-solvent mixture for application to the substrate. The functional material, particularly when in the form of nanoparticles, is suspended in a carrier system, for application.

After the composition of the functional material and the liquid has been applied to at least the raised surface of the stamp, some or all of the liquid from the composition is removed and the functional material remains on the stamp. The liquid from the composition on the relief structure is removed sufficiently to form a film of the functional material on at least the raised surface of the stamp. If more than one compound is used as the liquid for the functional material composition, some or all of the more than one compound are removed to form the film. Removing by may be accomplished in any manner, including, using gas jets, blotting with an absorbent material, evaporation at room temperature or an elevated temperature, etc. In one embodiment, removing can occur by drying during the application of the functional material on the stamp. Effective drying can be aided by selecting a solvent for the functional material that has a relatively low boiling point and/or by application of very thin layer (i.e., less than about 1 micron) of the composition of the functional material. The liquid is sufficiently removed from the composition layer provided that a pattern of the functional material according to the relief structure transfers to the substrate. In one embodiment, the film of the functional material on the stamp has a thickness between 0.001 and 2 micron. In another embodiment, the film layer of functional material on the stamp has a thickness between 0.01 to 1 micron.

In one embodiment the functional material is substantially free of liquid, that is the solvent or carrier, to form a film on the relief structure. In another embodiment, the liquid is substantially removed from the composition form a dried film of the functional material on at least the raised surface, and the dried film is exposed to a compound in its vaporized state in order to enhance transfer to the substrate. The vaporized compound is not limited, and can include water vapor or an organic compound vapor. Although not limited to the following, it is contemplated that the exposure of the dried film to the vaporized compound plasticizes the dried film to the extent that the film becomes slightly more malleable and increases the capability of the functional material to adhere to the substrate. Typically the effect of the vaporized compound on the dried film is temporary and transfer of the film to the substrate should immediately follow or substantially immediately follow.

Transferring the functional material from the raised surface of the relief structure to the substrate creates a pattern of the functional material on the substrate. Transferring may also be referred to as printing. Contacting the functional material on the raised surface to the substrate transfers the functional material, such that the pattern of functional material forms when the stamp is separated from the substrate. In one embodiment, all or substantially all the functional material positioned on the raised surface(s) transfer to the substrate. The separation of the stamp from the substrate may be accomplished by any suitable means, including but not limited to peeling, gas jets, liquid jets, mechanical devices etc.

Optionally, pressure may be applied to the stamp to assure contact and complete transfer of the functional material to the substrate. Suitable pressure used to transfer the functional material to the substrate is less than 5 lbs./cm², preferably less than 1 lbs./cm², more preferably 0.1 to 0.9 lbs./cm², and most preferably about 0.5 lbs./cm². Transfer of the functional material to the substrate may be accomplished in any manner. Transferring the functional material may be by moving the relief surface of the stamp to the substrate, or by moving the substrate to the relief surface of the stamp, or by moving both the substrate and the relief surface into contact. In one embodiment, the functional material is transferred manually. In another embodiment, the transfer of the functional material is automated, such as, for example, by a conveyor belt; reel-to-reel process; directly-driven moving fixtures or pallets; chain, belt or gear-driven fixtures or pallets; a frictional roller; printing press; or a rotary apparatus. The thickness of the layer of functional material is not particularly limited, with typical thickness of the layer of functional material on the substrate between 10 to 10000 angstrom.

The present method typically occurs at room temperature, that is, at temperatures between 17 to 30°C (63 to 86°F), but is not so limited. The present method can occur at an elevated temperature, up to about 100°C, provided that the heat does not detrimentally impact the elastomeric stamp, the functional material, and the substrate and their ability to form the pattern on the substrate.

The substrate is not limited, and can include, plastic, polymeric films, metal, silicon, glass, fabric, paper, and combinations thereof, provided that the pattern of functional material can be formed thereon. The substrate can be opaque or transparent. The substrate can be rigid or flexible. The substrate may include one or more layers and/or one or more patterns of other materials, before the pattern of the functional material according to the present method is formed on the substrate. A surface of the substrate can include an adhesion-promoting surface, such as a primer layer, or can be treated to promote adhesion of an adhesive layer or the functional material to the substrate. Suitable substrates include, for example, a metallic film on a polymeric, glass, or ceramic substrate, a metallic film on a conductive film or films on a polymeric substrate, metallic film on a semiconducting film on a polymeric substrate. Further examples of suitable substrates include, for example, glass, indium-tin-oxide coated glass, indium-tin-oxide coated polymeric films; polyethylene terephthalate, polyethylene naphthalate, polyimides , silicon, and metal foils. The substrate can include one or more charge injection layers, charge transporting layers, and semiconducting layers on to which the pattern is transferred.

Optionally, the pattern of functional material on the substrate may undergo further treatment steps such as, heating, exposing to actinic radiation sources such as ultraviolet radiation and infrared radiation, etc. In an embodiment where the functional material is in the form of nanoparticles, the additional treatment step may be necessary to render the functional material operative. For instance, when the functional material is composed of metal nanoparticles, the pattern of functional material may be heated to sinter the particles and render the lines of the pattern conductive. Sintering is forming a coherent bonded mass by heating a metal powder, such as in the form of nanoparticles, without melting. Heating the conductive material to a temperature less than about 220°C, and preferably less than about 140°C, sinters the nanoparticle conductive material into a continuous functional film.

The present method provides a method to form a pattern of a functional material on a substrate for use in devices and components in a variety of applications, including but no limited to, electronic, optical, sensory, and diagnostic applications. The method can be used to form patterns of active materials or inactive materials for use in electronic devices and components and in optical devices and components. Such electronic and optical devices and components include, but are not limited to radio frequency tags (RFID), sensors, and memory and backpanel displays. The method can be used to form patterns of conductive materials, semiconductive materials, dielectric materials on the substrate. The method can be used to form patterns of biological materials and pharmacologically active materials on the substrate for use in sensory or diagnostic applications. The method can form the functional material into a pattern that forms barrier walls for cells or pixels to contain other materials, such as light emitting materials, color filter pigmented materials, or a pattern that defines the channel length between source and drain electrode delivered from solution. The pattern of barrier walls may also be referred to as a confinement layer or barrier layer. The method can form the functional material into a pattern that forms barrier walls that creates cells for use as color filter pixels. The color filter pixels can be filled with colorant materials for color filters, including pigmented colorants, dye colorants. The method can form the functional material into transistor channels for top gate devices in which other materials, such as source materials and drain materials, are delivered to the channels. The method can form the functional material into transistor channels on a semiconducting layer of the substrate for bottom gate devices in which source materials and drain materials are delivered to the channels. The other materials can be delivered into the cells on the substrate as a solution by any means, including ink jet.

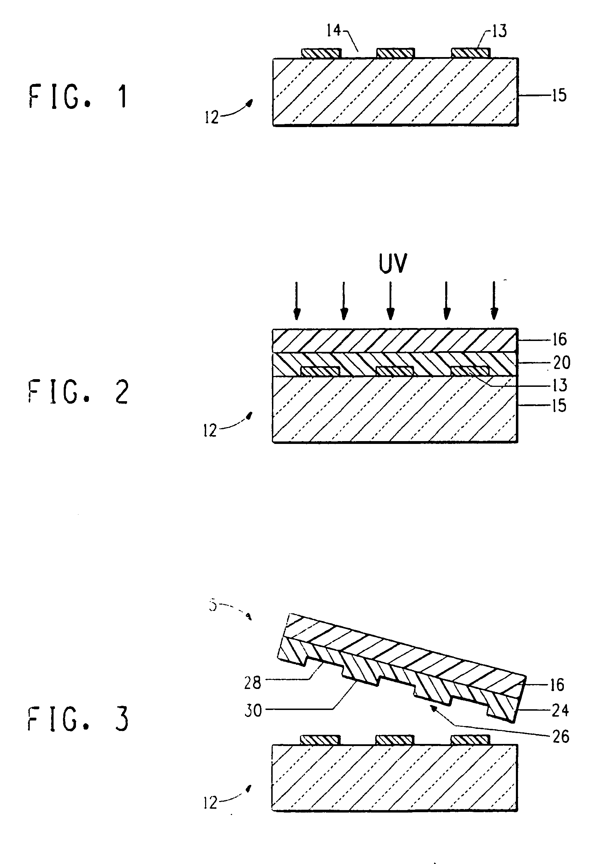

Figures 1 through 3 show one embodiment of a method of preparing a stamp 5 from a stamp precursor 10 in a molding operation. Figure 1 depicts a master 12 having a pattern 13 of a negative relief of the microelectronic features formed on a surface 14 of a master substrate 15. The master substrate 15 can be any smooth or substantially smooth metal, plastic, ceramic or glass. In one embodiment the master substrate is a glass or silicon plane. Typically the relief pattern 13 on the master substrate 15 is formed of a photoresist material, according to conventional methods that are well within the skill in the art. Plastic grating films and quartz grating films can also be used as masters. If very fine features on the order of nanometers are desired, masters can be formed on silicon wafers with e-beam radiation.

The master 12 may be placed in a mold housing and/or with spacers (not shown) along its perimeter to assist in the formation of a uniform layer of the photosensitive composition. The process to form the stamp can be simplified by not using the mold housing or spacers.

In Figure 2, a photosensitive composition is introduced to form a layer 20 onto the surface of the master 12 having the relief pattern 13. The photosensitive composition can be introduced on to the master 12 by any suitable method, including but not limited to, injection, pouring, liquid casting and coating. In one embodiment, the photosensitive composition is formed into the layer 20 by pouring the liquid onto the master. The layer of the photosensitive composition 20 is formed on the master 12 such that after exposure to actinic radiation, the cured composition forms a solid elastomeric layer having a thickness of about 5 to 50 micron. In the embodiment shown, a support 16 is positioned on a side of the photosensitive composition layer 20 opposite the master 12 such that an adhesive layer if present, is adjacent the layer of the photosensitive composition, to form the stamp precursor 10. The support 16 can be applied to the composition layer in any manner suitable to attain the stamp precursor 10. Upon exposure to actinic radiation, which is ultraviolet radiation in the embodiment shown, through the transparent support 16 of the stamp precursor 10, the photosensitive layer 20 polymerizes and forms an elastomeric layer 24 of the composition for the stamp 5. The layer of the photosensitive composition 20 cures or polymerizes by exposure to actinic radiation. Further, typically the exposure is conducted in a nitrogen atmosphere, to eliminate or minimize the presence of atmospheric oxygen during exposure and the effect that oxygen may have on the polymerization reaction.

The printing form precursor can be exposed to actinic radiation, such as an ultraviolet (UV) or visible light, to cure the layer 20. The actinic radiation exposes the photosensitive material through the transparent support 16. The exposed material polymerizes and/or crosslinks and becomes a stamp or plate having a solid elastomeric layer with a relief surface corresponding to the relief pattern on the master. In one embodiment, suitable exposure energy is between about 10 and 20 Joules on a 365nm I-liner exposure unit.

Actinic radiation sources encompass the ultraviolet, visible, and infrared wavelength regions. The suitability of a particular actinic radiation source is governed by the photosensitivity of the photosensitive composition, and the optional initiator and/or the at least one monomer used in preparing the stamp precursor. The preferred photosensitivity of stamp precursor is in the UV and deep visible area of the spectrum, as they afford better room-light stability. Examples of suitable visible and UV sources include carbon arcs, mercury-vapor arcs, fluorescent lamps, electron flash units, electron beam units, lasers, and photographic flood lamps. The most suitable sources of UV radiation are the mercury vapor lamps, particularly the sun lamps. These radiation sources generally emit long-wave UV radiation between 310 and 400 nm. Stamp precursors sensitive to these particular UV sources use elastomeric-based compounds (and initiators) that absorb between 310 to 400 nm.

In Figure 3, the stamp 5, which includes the support 16, is separated from the master 12 by peeling. The support 16 on the stamp 5 is sufficiently flexible in that the support and the stamp can withstand the bending necessary to separate from the master 12. The support 16 remains with the cured elastomeric layer 24 providing the stamp 5 with the dimensional stability necessary to reproduce micropattems and microstructures associated with soft lithographic printing methods. The stamp 5 includes on a side opposite the support 16 a relief structure 26 having recessed surfaces 28 and raised surfaces 30 corresponding to the the negative of the relief pattern 13 of the master 12. The relief structure 26 has a difference in height between the raised portion 30 and the recessed portion 28, that is a relief depth. The relief structure 26 of the stamp 5 forms a pattern of raised surfaces 30 for printing the functional material 32 on a substrate 34 and recessed surface portions 28 which do not print.

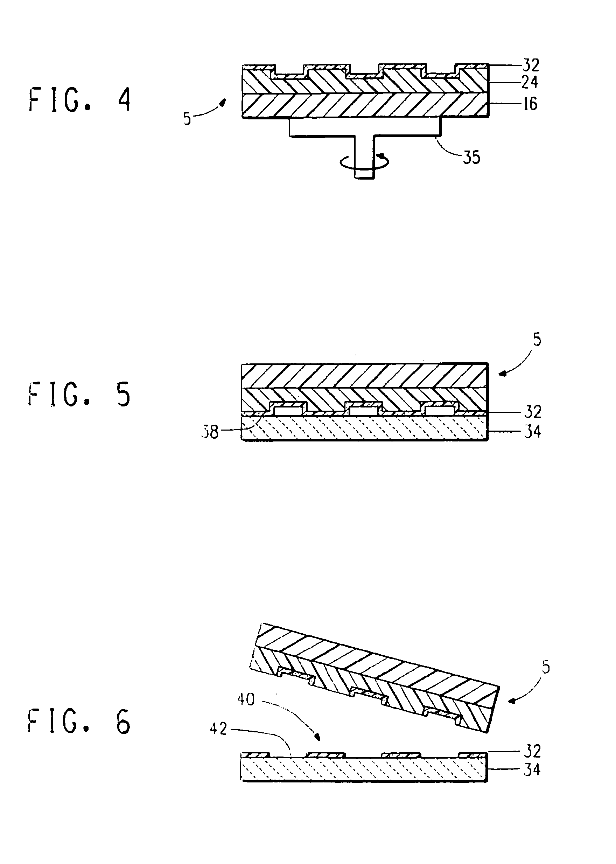

In Figure 4, the stamp 5 resides on a platform 35 of a spin coating device as one embodiment for applying the functional material 32 onto the relief structure 26 of the stamp 5. The functional material 32 is applied to the relief structure 26 of the stamp 5 and the platform is rotated to form a relatively uniform, continuous layer of the functional material. After application to the stamp 5 the functional material is dried to remove the liquid carrier by evaporation at room temperature.

In Figure 5, the stamp 5 having the layer of functional material 32 and the substrate 34 are positioned adjacent one another so that the functional material on the raised surfaces 30 of the stamp 5 contact a surface 38 of the substrate 34.

In Figure 6, the stamp 5 is separated from the substrate 34, and the functional material 32 contacting the substrate remains on the substrate, transferring to form a pattern 40 of the functional material. The substrate 34 includes the pattern 40 of functional material 32 and open areas 42 where no functional material resides. The functional material 32 that resides on the substrate 34 creates a pattern 40 for the electronic device or component.

The present method uses an elastomeric stamp having a modulus of elasticity of at least 10 MegaPascal (Mpa), which provides the capability to form features of various functional materials on the substrate of less than 50 micron resolution to at least as fine as 1 to 5 micron. The capability of the present method to form a pattern of functional material of suitable line resolution may be influenced by, but by no means limited to, the choice of material for the elastomeric stamp, the functional material being printed, the composition of the functional material, the conditions at which the present method is conducted, etc.. It will be appreciated that determining optimal materials and conditions to provide the desired line resolution for end-use applications in electronic devices and components would be routine to those of ordinary skill in the art.

### EXAMPLES

### Glossary

| | |
|---|---|
| ITO | indium tin oxide |
| PFPE | Perfluoropolyether |
| THF | Tetrahydrofuran |

Unless otherwise indicated, all percentages are by weight of the total composition.

### Example 1

The following example demonstrates printing of a light emitting polymer (LEP) onto a substrate with a printing stamp made of polyfluoropolyether (PFPE).

### Printing Stamp Preparation

### Master preparation:

A 1.5 micrometer thick layer of a negative photoresist, SU-8 type 2 (from MicroChem, Newton, MA) was coated onto a silicon wafer at 3000 rpm for 60 sec. The wafer with the coated photoresist film was heated 65°C for 1 minute and then baked at 95°C for 1 minute to fully dry the film. The baked film was then exposed for 12 sec in I-liner (OAI Mask Aligner, Model 200) at 365 nm through a mask having a pattern of lines and spaces and squares with dimensions varying from 1 to 5 micron, and post-baked at 65°C for 1min. After a final bake at 95°C for 1 minute the exposed photoresist was developed in SU-8 developer for 1 minute and washed with isopropyl alcohol. The developed film was dried with nitrogen and formed a pattern on the wafer, which was used as a master for the stamp.

### Stamp precursor preparation:

A support was prepared by applying a layer of a UV curable optically-clear adhesive, type NOA73, (purchased from Norland Products; Cranbury, NJ) at a thickness of 5 microns onto a 5 mil (0.0127 cm) Melinex® 561 polyester film support by spin coating at 3000 rpm and then curing by exposure to ultraviolet radiation (350-400 nm) at 1.6 watts power (20 mWatt/cm²) for 90 seconds in a nitrogen environment.

A polyfluoropolyether compound was prepared by the following procedure. A solution of FLK-D20 Diol purchased from Solvay Solexsis (Thorofare, NJ) (10gr, 0.005 mol, 1 eqv.) and BHT (1wt% FLK-D20 0.001gr) in anhydrous THF (100ml) was allowed to stir in a 3-neck round bottom reaction flask (250ml) equipped with a dropping funnel, thermometer, condenser and N₂ purge adapter. The reaction flask was cooled down to 0°C using an ice-water bath. Triethylamine (1.948gr, 0.0193 mol, 3.85 eqv.) was added dropwise to the solution of FLK-D20 Diol in THF over a 15 minute period. The reaction was maintained at 0°C. A second dropping funnel charged with acryloyl chloride (1.585gr, 0.0185 mol, 3.5 eqv.) was added dropwise to the solution over a 60 min period. The temperature of the mixture was not allowed to exceed 5°C. A thick salt precipitated out upon addition of the acryloyl chloride. The mixture was allowed to warm up to 10-15°C for 2 hours, then allowed to reach room temperature where the reaction stirred overnight under a N₂ atmosphere. The reaction mixture was poured into 500ml of distilled water and stirred for 2 hrs. The D20-DA was extracted from the water solution with ethyl acetate or methylene chloride; providing about 83% conversion. Crude product was purified by running the solution through an alumina column to yield a clear, colorless oil. The structure of the prepared perfluoropolyether (pre-polymer) compound was according to the following formula wherein the acrylate end-groups (where X and X' are H), and m and n, which designate the number of randomly distributed perfluoromethyleneoxy (CF₂O) and perfluoroethyleneoxy (CF₂CF₂O) backbone repeating subunits, is such that the PFPE compound has a molecular weight of about 2000 based on a number average.

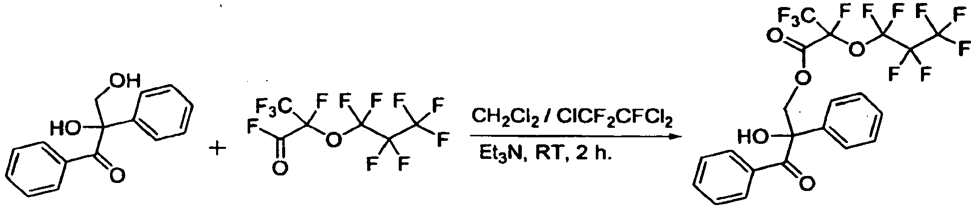

A fluorinated initiator was prepared according to the following reaction in the following procedure.

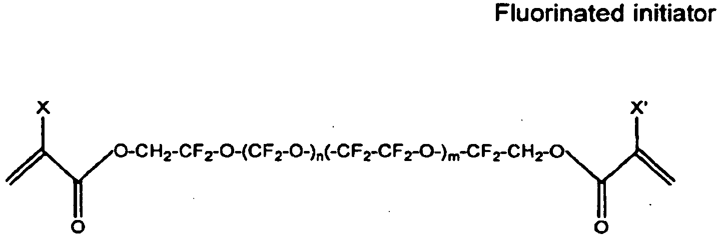

| | | Molar | Reaction | | | |
|---|---|---|---|---|---|---|
| Compound | Structure | Mass (g) | Mass (g) | Moles | Volume (mL) | Equiv. |
| Alpha-hydroxymethylbenzoin | C₁₅H₁₄O₃ | 242.27 | 20.00 | 0.083 | | 1.00 |
| HFPO-dimer acid fluoride | C₆F₁₂O₂ | 332.044 | 32.89 | 0.099 | | 1.20 |
| Methylene Chloride | | | | | 100 | |
| Freon-113 | | | | | 60 | |
| Triethylamine | Et₃N | 101.19 | 8.35 | 0.083 | | 1.00 |
| Product | C₂₁H₁₃F₁₁ O₅ | 554.307 | 45.76 | 0.083 | | |

### Procedure to prepare the fluorinated photoinitiator:

To a 500 mL round bottom flask was added α-hydroxymethylbenzoin (20.14 g), triethylamine (Fluka, 8.40 g) and methylene chloride (100 mL). The mixture was magnetically stirred under positive nitrogen pressure at room temperature. To a separate flask was added HFPO dimer acid fluoride (32.98 g) and Freon-113 (CFCl₂CF₂Cl, Aldrich, 60 mL). The acid fluoride solution was added dropwise to the stirring α-hydroxymethylbenzoin solution at 4-5 °C over 30 minutes in order to control the exothermic reaction. The reaction pot stirred for 2.5 hrs at room temperature after the addition was complete.

The reaction was washed with 4 x 500mL saturated NaCl solution. The organic layer was dried over MgSO₄ and filtered over a celite/methylene chloride pad. TLC analysis indicated a small amount of starting material remained in the crude product. The product was concentrated *in vacuo* and then dissolved in hexanes (100 mL). This solution was pre-absorbed onto silica gel and washed through a silica column using 90:10 hexanes:EtOAc eluent. The desired product was isolated as a light yellow oil which was a mixture of diastereomers (33g, 72% yield).

The PFPE diacrylate prepolymer (molecular weight about 2000) and 1 wt% by weight of the prepared fluorinated photoinitiator were mixed and filtered with 0.45 micrometer PTFE filter, forming a PFPE photosensitive composition.

The printing stamp was prepared by pouring the PFPE photosensitive composition onto the developed photoresist pattern of the wafer used as a master, forming a layer having a wet thickness of about 25 micron.
The support was applied to the layer of the PFPE composition on a surface opposite the master such that the adhesive was in contact with the layer. The PFPE layer was exposed to UV radiation for 10 min on the 365nm I-liner, to cure or polymerize the PFPE layer and form a stamp. The stamp was then separated by peeling from the master and had a relief surface that corresponded to the pattern in the master.

### Modulus of Elasticity Test Method:

The modulus of elasticity for the printing stamp was measured on a Hysitron Tribolndenter (Hysitron Inc., Minneapolis MN) and determined according to the test method described by Oliver and Pharr in J. Mater. Res. 7, 1564 (1992). The Tribolndenter was equipped with a Berkovich diamond indentor to perform indentations on a sample of the elastomeric stamp. For each stamp, at least two sets of twenty-five indentations to a maximum load of 100 microNewtons were conducted. Any surface effect and interaction with a substrate were minimized by indenting more than ten times the measured surface roughness, but not more than 10% of the total thickness of the sample. Indentations within each set were 10um apart, and the sets were separated by at least 1 mm. The indentations were made using a 5-2-5 load function in which 5 second to apply the load, 2 second of hold (under load control closed-loop feedback) to reduce the effect of hysteresis/creep, then a 5 second unload. The analysis of the Load/ Unload curves for each indentation were performed following the method of Oliver and Pharr to determine the modulus of elasticity. Seventy-five percent of the unload portion of the curve starting from 5 % from the top to 20% from the bottom was used for the calculation to determine the modulus of elasticity. The indenter area function that was required for analysis of the nanoindentation data using this method was calculated using a series of indents in fused silica.

The printing stamp had a modulus of elasticity of 20 MegaPascal. Dry transfer printing of a light emitting polymer (LEP) on a substrate:

The substrate was a purchased from NeoVac Company (Santa Rosa, CA) and had an indium-tin oxide (ITO) having a sheet resistance of 70ohm/□ on a 5 mil thick Mylar® polyethylene terephthalate support.

The LEP was COVION® Super NRS-PPV (from Merck). A 0.5 wt% by weight of the Super NRS-PPV solution in toluene was prepared in a nitrogen dry box and filtered with a PTFE 1.5 micron filter. The structure of the LEP follows:

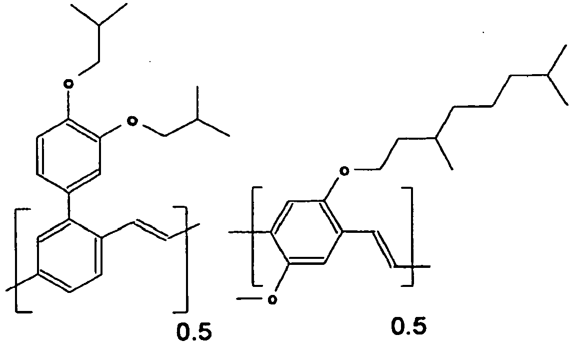

The NRS-PPV solution was spun coated onto the relief surface of the PFPE stamp at 4500 rpm, to coat and form a dry film on the stamp. The relief surface of the stamp included raised portions each having an uppermost planar surface and recessed portions each having a lowermost planar surface. The solution coated the uppermost surface of the raised portions and the lowermost surface of the recessed portions.

The dried NRS-PPV on the uppermost surface of the raised portions of the PFPE stamp was transferred by contact printing the raised portions onto the ITO surface of the substrate, and created a pattern of the Super NRS-PPV light emitting polymer on the substrate. The Super NRS-PPV had a thickness of 28 nm. The printed pattern of the LEP had resolution of 5 micron or less.

### Example 2

The following example demonstrates printing of another light emitting polymer (LEP) onto a substrate with a printing stamp made of PFPE.

The master and the PFPE stamp were prepared as described in Example 1.

### Printing of LEP on substrate:

The LEP solution was OC1-C10 which is a poly(p-phenylenevinylene) derivative from Hoechst, and has the following structure.

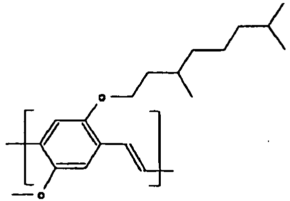

A 0.5 % by weight solution of the OC1-C10 in THF/toluene (50/50 v/v) was prepared and maintained in a nitrogen dry box. The solution was spun coated onto the relief surface of the PFPE stamp at 4500 rpm in a dry nitrogen atmosphere to coat and dry the OC1-C10 as a layer on the stamp.

The substrate used was the same as the substrate described in Example 1. The OC1-C10 on the uppermost surface of the raised portions of the PFPE was printed by contact transfer onto the ITO surface of the substrate. The transfer was accomplished by placing the ITO substrate on hot plate maintained at 65°C under a dry nitrogen atmosphere and by applying a small pressure to the stamp. A pattern of the OC1-C10 light emitting polymer was created on the substrate according to the pattern of the raised portions of the stamp.

The thickness of the printed OC1-C10 film layer on the substrate was 32 nm. The printed pattern of the LEP had resolution of less than 10 micron.

### Example 3

The following example demonstrates printing of a dielectric material onto a substrate with a printing stamp made of PFPE.

The dielectric materials printed were Elvacite® 2042, a poly(ethyl methacrylate), and Elvacite® 2045, a poly(butyl methacrylate), both from Lucite International. The substrate was a silicon wafer having a layer of SiO₂ that had a thickness of about 3000Angstrom.

For both of the printed samples of Example 3, the master and the PFPE stamp were prepared as described in Example 1, except that a different PFPE compound having a molecular weight of about 1000, and a different photoinitiator were used.

The perfluoropolyether compound E10-DA was used as received and supplied by Sartomer as product type CN4000. The E10-DA has a structure according to the following Formula, wherein R and R' are each an acrylate, E is a linear non-fluorinated hydrocarbon ether of (CH₂CH₂O)₁₋₂CH₂, and E' is a linear hydrocarbon ether of (CF₂CH₂O(CH₂CH₂O)₁₋₂, and having a molecular weight of about 1000.

R-E-CF₂-O-(CF₂-O-)ₙ(-CF₂-CF₂-O-)ₘ-CF₂-E'-R'

The photoinitiator was Darocur 1173 (from Ciba Specialty Chemicals, Basel, Switzerland). The structure of Darocur 1173 is as follows.

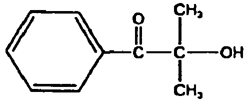

The PFPE diacrylate prepolymer E10-DA and 1 wt % the Darocur 1173 photoinitiator were mixed and filtered to form the PFPE composition that was used to make the printing stamp.

The modulus of elasticity for the printing stamp was measured as described in Example 1. The printing stamp had a modulus of elasticity of 40 MegaPascal.
Printing of Elvacite 2042 poly(ethyl methacrylate) on substrate:

A 1wt% solution of the poly(ethyl methacrylate) in methylene chloride as solvent was spun coated at 2000 rpm for 60sec onto the relief surface of the PFPE stamp.

Due to the very low boiling point of methylene chloride, the solvent fully evaporated during spinning of the film. A film of the poly(ethyl methacrylate) remained on the relief surface of the stamp. The relief surface of the stamp with the film was placed adjacent the SiOx surface of the wafer, and at 65°C, a gentle pressure was applied to the stamp onto the substrate. The film was printed by contact transfer from the uppermost surface of the raised portions of the relief. The stamp was separated from the substrate, and the pattern of the dielectric film transferred to the substrate.

The transferred film of the poly(ethyl methyacrylate) had a thickness of about 0.125 micrometers. The printed pattern of the poly(ethyl methacrylate) had resolution of 50 micron or less.
Printing of Elvacite 2045 poly(ethyl methacrylate) on substrate:

A 1wt% solution of the poly(butyl methacrylate) in chloroform as solvent was spun coated at 2000 rpm for 60sec onto the relief surface of the PFPE stamp.

After the solvent fully evaporated as described above, a film of the poly(buytyl methacrylate) remained on the relief surface of the stamp. The relief surface of the stamp with the film was placed adjacent the SiOx surface of the wafer, and at 65°C, a gentle pressure (~0.5 lbs /cm²) was applied to the stamp onto the substrate. The film was printed by transfer from the uppermost surface of the raised portions of the relief. The stamp was separated from the substrate and a pattern of the poly(ethyl methacrylate) transferred to the substrate. The transferred film of the poly(butyl methyacrylate) cast from chloroform had a thickness of about 70 nanometers. The printed pattern of the poly(butyl methacrylate) had resolution of 50 micron or less.

### Example 4

The following example demonstrates printing of a dielectric material, poly 2-vinyl pyrilidone (molecular weight of 20,000) from Aldrich, onto a substrate using a PFPE stamp. The substrate was a silicon wafer having a layer of SiO₂ (3000Angstrom).

The master and PFPE stamp were prepared as described in Example 1.
Dry transfer printing of the dielectric material on substrate:

A 1% by weight solution of the poly(2-vinyl pyrrolidone) in chloroform was spun coated at 2000 rpm for 60 seconds on the relief surface of the PFPE stamp. The chloroform evaporated during spinning to leave a film of the 2-vinyl pyrrolidone on the raised portions and recessed portions of the relief surface of the stamp. The relief surface of the stamp with the film was placed adjacent the SiO₂ surface of the wafer, and at room temperature, a gentle pressure was applied to the stamp onto the substrate. The film was printed from the uppermost surface of the raised portions of the relief to form a pattern of the poly (2-vinylpyrrolidone) on the substrate. The stamp was separated from the substrate and the poly(2-vinyl pyrrolidone) film transferred from the PFPE stamp to the SiO₂ surface of the silicon wafer.

The transferred film of poly(2-vinyl pyrrolidone) had a thickness on the wafer of about 47 nm. The printed pattern of the poly-2-vinyl pyrilidone had resolution of 5 micron or less.

### Example 5

The following example demonstrates printing of a dielectric material onto a substrate using a PFPE stamp.

The dielectric material was a poly hydroxyl styrene (PHS) (molecular weight of about 20,000) from Aldrich. The substrate was a silicon wafer having a layer of SiO₂ (3000Angstrom).

The master and PFPE stamp were prepared as described in Example 1.
Dry transfer printing of the dielectric material on the substrate:

A 5% by weight solution of the PHS in THF was spun coated at 2000 rpm for 60 seconds onto the relief surface of the PFPE stamp. The solvent in the THF solution evaporated during spin coating leaving a dry film of the PHS on at least the raised portions of the relief surface of the stamp. The relief surface of the stamp with the film was placed adjacent the SiO₂ surface of the wafer, and at 65 °C a gentle pressure (-0.5 lb/cm²) was applied to the support side of the stamp to contact the film onto the substrate. The dry film was printed by contact transfer of the uppermost surface of the raised portions of the relief stamp. The stamp was separated from the substrate and a patterned film of PHS transferred to the SiO₂ surface of the silicon wafer.

The transferred film of PHS had a thickness of about 290 nm. The printed pattern of the PHS had resolution of 50 micron or less.

### Example 6

The following example demonstrates printing of semiconductor material onto a substrate using a PFPE stamp.

The semiconductor material was a polythiophene from Aldrich. The substrate was a silicon wafer having a layer of SiO₂ (3000Angstrom).

The master and PFPE stamp were prepared as described in Example 1.

### Dry transfer printing of a semiconductor material onto a substrate:

A 1.2% by weight solution of the polythiophene in chloroform was spun coated at 2000 rpm for 60 seconds on to the relief surface of the PFPE stamp. The solvent in the polythiophene solution evaporated during spinning to leave a film of the polythiophene on the relief surface of the stamp. The relief surface of the stamp with the dried film was placed adjacent the SiO₂ surface of the wafer, and at 60°C a gentle pressure (about 0.5 lb/cm²) was applied to the support side of the stamp to contact the film onto the substrate. The film was printed by contact transfer of the uppermost surface of the raised portions of the relief to the substrate. The stamp was separated from the substrate, transferring to form a pattern of the polythiophene film on the SiO₂ surface of the silicon wafer.

The transferred film of polythiophene had a thickness of about 290 nm. The printed pattern of the polythiophene had resolution of 50 micron or less.

### Example 7

The following example demonstrates printing of a conductive material onto a substrate using a PFPE stamp.

The conductive material was a polyaniline di-nonyl naphthalene sulfonic acid (PANI/DNNSA) from DuPont. The substrate was a silicon wafer having a layer of SiO₂ (3000Angstrom).

The master and PFPE stamp were prepared as described in Example 1.

### Dry transfer printing of the conductive material on the substrate:

A 15% by weight solution of the PANI/DNNSA in xylene was spun coated at 2000 RPM for 60 seconds onto the relief surface of the PFPE stamp. The solvent in the PANI/DNNSA solution evaporated during spinning leaving a film of the PANI/DNNSA on the raised portions and the recessed portions of the relief surface of the stamp. The relief surface of the stamp with the film was placed adjacent the SiO₂ surface of the wafer, and at 65°C a gentle pressure was applied to the support side of the stamp to contact the film onto the substrate. The film was printed by contact transfer from the uppermost surface of the raised portions of the relief surface. The stamp was separated from the substrate and a patterned film of the PANI/DNNSA transferred from the PFPE stamp to the SiO₂ surface of the silicon wafer.

The transferred film of PANI/DNNSA had a thickness of about 290 nm. The printed pattern of the PANI/DNNSA had resolution of 50 micron.

### Example 8A

The following example demonstrates the printing of a conductive material on to a substrate using a PFPE stamp.

The conductive material was Silverjet DGH50, which is silver powder having particle size of 10 nm produced by ANP (South Korea). The substrate was a 5 mil Melinex® polyester film type ST504.

The master and PFPE stamp were prepared as described in Example 1. The PFPE stamp had a modulus of elasticity of 20 MegaPascal.

### Dry transfer printing of conductive material on to substrate:

A dispersion of 9.9 grams of the Silverjet DGH50 and 0.1 grams of Elvacite® type 2028, a methacrylate copolymer (from Lucite) were mixed in 40 grams of toluene and sonicated with a tip sonicator for 10 minutes. The dispersion was twice filtered through a 0.45 micron PTPE filter. The filtered dispersion was spun coated for 60 seconds onto the relief surface of the PFPE stamp. The solvent in the dispersion was evaporated during spinning to leave a film of the silver and Elvacite 2028 on the raised portions and the recessed portions of the relief surface of the stamp. The relief surface of the stamp with the silver film was placed adjacent the Melinex® film and at 65°C a gentle pressure was applied to the support side of the stamp to contact the film onto the substrate. The film was printed by contact transfer from the uppermost surface of the raised portions of the relief to the substrate. The stamp was separated from the substrate to form a pattern of the silver film on the substrate.

The silver pattern on the substrate was fired and sintered at 140°C for 48 hours, which decreased the sheet resistance of the silver film to 2 ohm/□
The transferred film of the patterned silver had a thickness of about 70 nm. The printed pattern of the silver had resolution of 5 micron or less.

### Example 8B- Comparative

The following example demonstrates the printing of a conductive material on to a substrate using a PDMS stamp.

Example 8A was repeated except that a stamp of polydimethylsiloxane (PDMS) was prepared as follows using the same master as was used for the PFPE stamp.

### PDMS stamp preparation:

Sylgard 184, a polydimethylsiloxane, and a curing agent (both from Dow Corning) were mixed at a ratio 10:1. The mixture was degassed and poured onto the photoresist patterned silicon wafer master. After a 5 mil thick polyester backing Melinex® 561, (from DuPont) was applied, the prepolymer was cured by heating at 65°C for 120min. The stamp of a cured PDMS on polyester support was separated from the master.

The modulus of elasticity for the printing stamp was measured as described in Example 1. The PDMS printing stamp had a modulus of elasticity of 5.6 MegaPascal.

### Dry transfer printing of conductive material on to substrate:

The same procedure for applying the silver composition, drying, and printing the film of silver and Elvacite 2028 that was used with the PFPE stamp was repeated for the PDMS stamp. Upon the application of pressure the silver film delaminated from the PDMS stamp transferring the silver material from both the raised portions and the recessed portions to the substrate such that no pattern of the silver material was formed on the substrate. The silver material was fired and sintered as described above, which decreased the sheet resistance of the unpatterned film to 2.2 ohm/□

### Example 9

The following example demonstrates dry printing of small molecules with a stamp of PFPE.

The master and PFPE stamp were prepared as described in Example 1.

### Dry transfer printing of a small molecule on a substrate:

A 5% solution of brilliant green dye material (MW 482.65) (from Aldrich, CAS number of [633-03-4]) in methylene chloride was prepared. The solution was spun-coated onto the PFPE stamp at 3000 rpm to coat and dry the solution on the stamp. The relief surface of the stamp included raised portions each having an uppermost planar surface and recessed portions each having a lowermost planar surface. The solution coated the uppermost surface of the raised portions and the lowermost surface of the recessed portions.

The dried film of dye material on the uppermost surface of the raised portions of the PFPE stamp was transferred by contact printing of the raised portions to a substrate of Melinex® 504 polyester film at 65°C by applying a gentle pressure (about 0.5 lbs/cm²). The stamp was separated from the substrate and the dye film on the uppermost surface of the relief pattern transferred to the substrate forming a pattern of the dye film.

The thickness of the transferred dye film was about 50 nm. The structure of the dye is shown in the right hand side of the following figure.

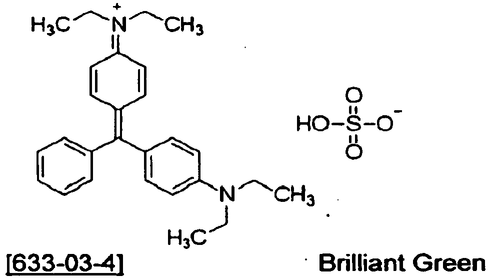

### Example 10

The following example demonstrates dry printing of DNA onto a substrate. The master and PFPE stamp were prepared as described in Example 1.

### Preparation of Deoxyribonucleic acid (DNA) Solution:

Highly polymerized DNA (salmon testes; purchased from Sigma-Aldrich Biochemical) (0.200 g) was added to doubly distilled water (40 mL). The resulting mixture was gently agitated on a nutating platform over a 24 h period affording a viscous homogeneous solution with a concentration near 0.5 weight-percent. An aliquot (20 ml) of the resulting solution was diluted with doubly distilled water (80 ml) giving a second solution with a concentration near 0.1 weight-percent. The 0.1 wt % DNA solution was gently agitated for an additional 12hr period and then were stored at 4°C in the dark until used for the spin coating procedure.

### Dry transfer printing of the DNA:

The 0.1 wt %DNA solution described above was spun-coated onto the PFPE stamp at 3000RPM to coat and form a dry film on the relief structure of the stamp. The relief surface of the stamp included raised portions each having an uppermost planar surface and recessed portions each having a lowermost planar surface. The solution coated the uppermost surface of the raised portions and the lowermost surface of the recessed portions.

The dried DNA film on the uppermost surface of the stamp was transferred by contact printing the raised portions onto a substrate of Melinex® type 504 polyester film, at 65°C by applying a gentle pressure (about 0.5 lbs/cm²). The stamp was separated from the substrate and the DNA film transferred from the PFPE stamp to form a pattern on the substrate.

The printed DNA retained its double-stranded character. DNA fluoresces in the presence of several probes: (1) ethidium bromide (a double helix intercalator) and (2) DAPI (a double helix groove binder). These qualitative, probe-based results suggest that a duplex (double stranded) geometry for the "printed" biopolymer was retained.

The printed pattern of DNA had a line resolution 5 microns or less.

### Example 11

The following example demonstrates printing of fluorine-containing monomers onto a substrate with a printing stamp made of PFPE.

The master and the PFPE stamp were prepared as described in Example 1.

### Printing of fluorine-containing monomers on substrate:

The fluorinated containing monomer was 3,3,4,4,5,5,6,6,7,7,8,8,9,9,10,10,11,11,12,12,12-Heneicosafluoro-dodecyl acrylate (from Aldrich, CAS No. [17741-60-5]), herein after referred to as Heneicosafluoro-dodecyl acrylate, and has the following structure.

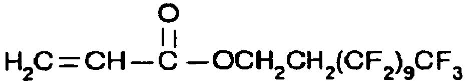

A 3 % by weight solution of the Heneicosafluoro-dodecyl acrylate in Vertrel® XF (from DuPont), having the formula CF₃CFHCFHCF₂CF₃, was prepared with 1wt% of fluorinated initiator of Example 1 based on the Heneicosafluoro-dodecyl acrylate. The solution was spun coated onto the relief surface of the PFPE stamp at 2000 rpm for 20sec, 3 times.

A substrate was prepared by spin coating a hole transport material polymer onto Corning 1737 glass (from Corning Inc.) at 3000rpm followed by thermal curing at 260°C for 15min. The hole transport material polymer is a fluorene-triarylamine copolymer and has the following structure. 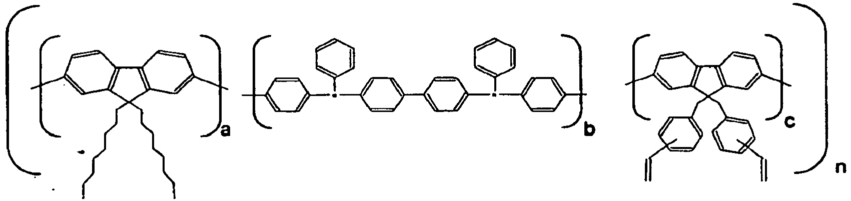 Wherein the ratio of a:b:c was about 35:50:15, such that the Mn was about 26,000 and the Mw was about 89,000. And wherein the starting materials for the hole transport material polymer were as follows.
a was 9,9-dioctyl-2,7-dibromofluorene
b was N,N'-bis(4-bromomphenyl)-N,N'-diphenylbenzidine
c was 2,7-dibromo-9,9'-(vinylbenzyl)-fluorene
The polymer was made by a synthetic method, as described in Yamamoto, Progress in Polymer Science, Vol. 17, p 1153 (1992), where the dihalo derivatives of the monomeric units are reacted with a stoichiometric amount of a zerovalent nickel compound, such as bis(1,5-cyclooctadiene)nickel(0).

The term "hole transport" when referring to a layer, material, member, or structure, is intended to mean that such layer, material, member, or structure facilitates migration of positive charges through the thickness of such layer, material, member, or structure with relative efficiency and small loss of charge.

The Heneicosafluoro-dodecyl acrylate on the uppermost surface of the raised portions of the PFPE was printed by contact transfer onto the surface of the substrate having the hole transport layer. The transfer was accomplished at room temperature and no pressure to the stamp was applied to form a pattern of the Heneicosafluoro-dodecyl acrylate on the substrate. After separating the stamp from the substrate, the patterned Heneicosafluoro-dodecyl acrylate was UV exposed using I-liner (17mW/cm², OAI) for 10min in a nitrogen environment to cure the monomer onto the substrate. The pattern of the Heneicosafluoro-dodecyl acrylate was created on the coated surface of the substrate according to the pattern of the raised portions of the stamp.

The thickness of the printed Heneicosafluoro-dodecyl acrylate layer on the substrate was 2 nm. The printed pattern of the Heneicosafluoro-dodecyl acrylate had resolution of less than 5 micron. It is expected that nanometer resolution could be achieved with this method for printing barrier layers.

### Example 12

The following example demonstrates printing of an organic light emitting polymeric material onto a substrate with a stamp made of polyfluoropolyether having a modulus of elasticity of 10.5 MegaPascal.

For this example the master and the PFPE stamp were prepared as described in Example 1, except that a different PFPE compound having a molecular weight of 4000 was used.

A polyfluoropolyether compound, D40-DA, was supplied by Sartomer and used as received. The polyfluoropolyether compound (pre-polymer) made had structure according to the Formula shown in Example 1, wherein the acrylate end-groups (where X and X' are H), and m and n, which designate the number of randomly distributed perfluoromethyleneoxy (CF₂O) and perfluoroethyleneoxy (CF₂CF₂O) backbone repeating subunits, is such that the PFPE compound has a molecular weight of about 4000 based on a number average. The photoinitiator used was Darocur 1173, as described in Example 3.

The perfluoropolyether prepolymer (molecular weight 4000) and 1wt % of the photoinitiator were mixed and filtered forming a PFPE photosensitive composition. The printing stamp was prepared from the PFPE photosensitive composition as described in Example 1. -

The modulus of elasticity for the printing stamp was measured as described in Example 1. The printing stamp had a modulus of elasticity of 10.5 MegaPascal.

### Printing of the organic light emitting polymer (OLEP) onto ST504 substrate:

A 1wt% solution of Covion Super-Yellow™, a substituted polyphenylene-vinylene 1-4 copolymer (from Merck), (hereinafter OLEP) was dissolved in toluene as solvent was spun coated at 4000 rpm for 60sec onto the relief surface of the PFPE stamp. The solvent fully evaporated during spinning of the film. A film of 50 nm of the OLEP remained on the relief surface of the stamp. The substrate was a 5 mil Melinex® film type ST504. The relief surface of the stamp with the film was placed adjacent the acrylic coated side of the ST504 film at 65°C. The film was printed by contact transfer from the uppermost surface of the
raised portions of the relief. The stamp was separated from the substrate, and the pattern of the OLEP film transferred to the substrate.

The transferred film of the OLEP had a thickness of about 50 nm. The printed pattern of the OLEP had resolution of 5 micron or less with 2 micron separation between the lines.

## Claims

1. A method to form a pattern of functional material on a substrate comprising:
a) providing an elastomeric stamp having a relief structure with a raised surface, the stamp having a modulus of elasticity of at least 10 MegaPascal wherein said elastomeric stamp is formed from a layer of a composition comprising a fluorinated compound capable of polymerization by exposure to actinic radiation:
b) applying a composition comprising the functional material and a liquid to the relief structure;
c) removing the liquid from the composition on the relief structure sufficiently to form a film of the functional material on at least the raised surface; and
d) transferring the functional material from the raised surface to directly form the pattern on the substrate.

2. The method of Claim 1 wherein the functional material has a thickness between 10 and 10000 angstrom on the substrate.

3. The method of Claim 1 wherein transferring step comprises contacting the raised surface of the stamp to the substrate with pressure less than about 5 lbs./cm²

4. The method of Claim 1 wherein the functional material is selected from the group consisting of conductive materials, semiconductive materials, dielectric materials, small molecule materials, bio-based materials, and combinations thereof.

5. The method of Claim 1 wherein the functional material is selected from the group consisting of electrically active materials, photoactive materials, and biologically active materials.

6. The method of Claim 1 wherein the functional material is selected from the group consisting of insulating materials, planarization materials, barrier materials, and confinement materials.

7. The method of Claim 1 wherein the functional material comprises one or more fluorinated compounds, the method further comprising step e) exposing the pattern of the fluorinated compound on the substrate to actinic radiation.

8. The method of Claim 1 wherein the functional material comprises nanoparticles selected from the group consisting of conductive materials, semi-conductive materials, and dielectric materials.

9. The method of Claim 1 wherein the functional material comprises nanoparticles of a conductive material, the method further comprising step e) sintering the nanoparticles on the substrate to form a continuous film of conductive material.

10. The method of Claim 9 wherein sintering comprises heating the nanoparticles to temperature up to about 220°C.

11. The method of Claim 1 wherein the functional material is a conductive material selected from the group consisting of silver, gold, copper, palladium, indium-tin oxide, and combinations thereof.

12. The method of Claim 1 wherein the functional material is selected from the group consisting of carbon nanotubes, conducting carbon nanotubes, semiconducting carbon nanotubes, and combinations thereof.

13. The method of Claim 1 wherein the fluorinated compound is a perfluoropolyether compound.

## Patentansprüche

1. Verfahren zur Strukturformung eines Funktionsmaterials auf einem Substrat, das die folgenden Schritte aufweist:
a) Bereitstellen eines elastomeren Stempels mit einer Reliefstruktur mit einer erhabenen Oberfläche, wobei der Stempel einen Elastizitätsmodul von mindestens 10 MPa aufweist, wobei der elastomere Stempel aus einer Schicht einer Zusammensetzung hergestellt wird, die eine fluorierte Verbindung aufweist, die durch Einwirken einer aktinischen Strahlung polymerisierbar ist;
b) Aufbringen einer Zusammensetzung, die das Funktionsmaterial und eine Flüssigkeit aufweist, auf die Reliefstruktur;
c) Entfernen der Flüssigkeit aus der Zusammensetzung auf der Reliefstruktur in ausreichender Weise, um einen Film des Funktionsmaterials auf mindestens der erhabenen Oberfläche zu bilden; und
d) Übertragen des Funktionsmaterials von der erhabenen Oberfläche, um direkt die Struktur auf dem Substrat zu bilden.

2. Verfahren nach Anspruch 1, bei dem das Funktionsmaterial eine Dicke zwischen 10 und 10000 Angström auf dem Substrat aufweist.

3. Verfahren nach Anspruch 1, bei dem der Schritt des Übertragens das Kontaktieren der erhabenen Oberfläche des Stempels mit dem Substrat bei einem Druck von weniger als etwa 5 lbs./cm² aufweist.

4. Verfahren nach Anspruch 1, bei dem das Funktionsmaterial aus der Gruppe ausgewählt wird, die besteht aus: leitenden Materialien; halbleitenden Materialien; dielektrischen Materialien; niedermolekularen Materialien; Materialien auf Biobasis; und deren Kombinationen.

5. Verfahren nach Anspruch 1, bei dem das Funktionsmaterial aus der Gruppe ausgewählt wird, die besteht aus: elektrisch aktiven Materialien; photoaktiven Materialien; und biologisch aktiven Materialien.

6. Verfahren nach Anspruch 1, bei dem das Funktionsmaterial aus der Gruppe ausgewählt wird, die besteht aus: Isoliermaterialien; Planarisicrungsmaterialien; Sperrmaterialien; und Begrenzungsmaterialien.

7. Verfahren nach Anspruch 1, bei dem das Funktionsmaterial eine oder mehrere fluorierte Verbindungen aufweist, wobei das Verfahren außerdem den Schritt e) des Einwirkens einer aktinischen Strahlung auf die Struktur der fluorierten Verbindung auf dem Substrat aufweist.

8. Verfahren nach Anspruch 1, bei dem das Funktionsmaterial Nanoteilchen aufweist, die aus der Gruppe ausgewählt werden, die besteht aus: leitenden Materialien; halbleitenden Materialien; und dielektrischen Materialien.

9. Verfahren nach Anspruch 1, bei dem das Funktionsmaterial Naonteilchen eines leitenden Materials aufweist, wobei das Verfahren außerdem den Schritt e) des Sinterns der Nanoteilchen auf dem Substrat aufweist, um einen kontinuierlichen Film aus leitendem Material zu bilden.

10. Verfahren nach Anspruch 9, bei dem der Schritt des Sinterns das Erhitzen der Nanoteilchen auf eine Temperatur bis zu etwa 220 °C aufweist.

11. Verfahren nach Anspruch 1, bei dem das Funktionsmaterial ein leitendes Material ist, das aus der Gruppe ausgewählt wird, die besteht aus: Silber; Gold; Kupfer; Palladium; Indium-Zinnoxid; und deren Kombinationen.

12. Verfahren nach Anspruch 1, bei dem das Funktionsmaterial aus der Gruppe ausgewählt wird, die besteht aus: Kohlenstoff-Nanoröhrehen; leitenden Kohlenstoff-Nanoröhrchen; halbleitenden Kohlenstoff-Nanoröhrchen; und deren Kombinationen.

13. Verfahren nach Anspruch 1, bei dem die fluorierte Verbindung eine Perfluorpolyether-Verbindung ist.

## Revendications

1. Procédé de formation d'un motif de matériau fonctionnel sur un substrat, comprenant les étapes ci-dessous :
a) fourniture d'un tampon élastomère comportant une structure en relief, avec une surface surélevée, le tampon présentant un module d'élasticité d'au moins 10 Mégapascals, ledit tampon élastomère étant formé à partir d'une couche d'une composition comprenant un composé fluoré pouvant être soumis à une polymérisation par suite de l'exposition à un rayonnement actinique ;
b) application d'une composition comprenant le matériau fonctionnel et un liquide sur la structure en relief ;
c) élimination du liquide de la composition sur la structure en relief, de manière suffisante pour former un film du matériau fonctionnel sur au moins la surface surélevée ; et
d) transfert du matériau fonctionnel à partir de la surface surélevée pour former directement le motif sur le substrat.

2. Procédé selon la revendication 1, dans lequel le matériau fonctionnel a une épaisseur comprise entre 10 et 10000 Angstrom sur le substrat.

3. Procédé selon la revendication 1, dans lequel l'étape de transfert comprend la mise en contact de la surface surélevée du tampon avec le substrat, avec une pression inférieure à environ 5 livres/cm².

4. Procédé selon la revendication 1, dans lequel le matériau fonctionnel est sélectionné dans le groupe constitué de matériaux conducteurs, de matériaux semi-conducteurs, de matériaux diélectriques, de matériaux à petites molécules, de matériaux d'origine biologique et de combinaisons de ces matériaux.

5. Procédé selon la revendication 1, dans lequel le matériau fonctionnel est sélectionné dans le groupe constitué de matériaux à activité électrique, de matériaux photoactifs et de matériaux à activité biologique.

6. Procédé selon la revendication 1, dans lequel le matériau fonctionnel est sélectionné dans le groupe constitué de matériaux isolants, de matériaux de planarisation, de matériaux de barrière et de matériaux de confinement.

7. Procédé selon la revendication 1, dans lequel le matériau fonctionnel comprend un ou plusieurs composés fluorés, le procédé comprenant en outre l'étape e) consistant dans l'exposition du motif du composé fluoré sur le substrat à un rayonnement actinique.

8. Procédé selon la revendication 1, dans lequel le matériau fonctionnel comprend des nanoparticules sélectionnées dans le groupe constitué de matériaux conducteurs, de matériaux semi-conducteurs et de matériaux diélectriques.

9. Procédé selon la revendication 1, dans lequel le matériau fonctionnel comprend des nanoparticules d'un matériau conducteur, le procédé comprenant en outre l'étape e) consistant en un frittage des nanoparticules sur le substrat pour former un film continu de matériau conducteur.

10. Procédé selon la revendication 9, dans lequel le frittage comprend le chauffage des nanoparticules à une température atteignant environ 220°C.

11. Procédé selon la revendication 1, dans lequel le matériau fonctionnel est un matériau conducteur sélectionné dans le groupe constitué d'argent, d'or, de cuivre, de palladium, d'oxyde d'étain et d'indium et de combinaisons de ces matériaux.

12. Procédé selon la revendication 1, dans lequel le matériau fonctionnel est sélectionné dans le groupe constitué de nanotubes de carbone, de nanotubes de carbone conducteurs, de nanotubes de carbone semi-conducteurs et de combinaisons de ces matériaux.

13. Procédé selon la revendication 1, dans lequel le composé fluoré est un composé de perfluoropolyéther.
